# EUROPÄISCHE PATENTSCHRIFT

(11) **EP 1 801 843 B1**
(45) Veröffentlichungstag und Bekanntmachung des Hinweises auf die Patenterteilung: **03.07.2013**
(21) Anmeldenummer: 06018138.5
(22) Anmeldetag: 30.08.2006
(51) Int. Cl.: H01J 37/18, C23C 14/56, H01L 21/00

(54) **Anlage und Verfahren zur Behandlung von Substraten**
Arrangement and method for the treatment of substrates
Installation et méthode pour le traitement de substrats

(30) Priorität: 22.12.2005 DE 10561563
(43) Veröffentlichungstag der Anmeldung: 27.06.2007
(73) Patentinhaber: Applied Materials GmbH & Co. KG, 63755 Alzenau (DE)
(72) Erfinder: Koparal, Erkan, 61130 Nidderau (DE); Haas, Dieter, 63486 Bruchköbel (DE)
(74) Vertreter: Bockhorni & Kollegen

(56) Entgegenhaltungen:
- EP-A- 1 319 732
- US-A1- 2002 170 671
- US-A1- 2005 208 731

## Beschreibung

Die Erfindung betrifft eine Anlage zur Behandlung von Substraten, umfassend wenigstens eine erste Prozesskammer, eine zweite Prozesskammer und eine dritte Prozesskammer zur Behandlung der Substrate, eine zentrale Transportkammer, an die die wenigstens drei Prozesskammern angeschlossen sind, und einen ersten Schleusenbereich zum Ein- oder Ausschleusen der Substrate in die Anlage bzw. aus der Anlage. Ferner betrifft die Erfindung ein Verfahren zur Behandlung von Substraten, insbesondere zur Durchführung in der oben angegebenen Anlage.

In einer Reihe von Anwendungen werden Substrate mehreren Behandlungsschritten, beispielsweise Beschichtungen, unterzogen. Eines von vielen Beispielen für eine Mehrfachbeschichtung von Substraten ist die TFT-Metallisierung (Thin Film Transistor), bei der zwei bis drei verschiedene Metalle durch Sputtern aufgetragen werden. Bei Schichtsystemen mit mehreren Schichten kann es erforderlich sein, die Schichtdicke der einzelnen Schichten unterschiedlich einzustellen. Mit der Schichtdicke verändert sich jedoch auch die Beschichtungszeit in einem bestimmten Beschichtungsschritt. Beispielsweise kann es nötig sein, bei der TFT-Metallisierung die zweite Schicht deutlich dicker auszubilden als die darunter liegende erste und die darüber liegende dritte Schicht.

Für die Herstellung derartiger Schichtsysteme mit mehreren Schichten wurden verschiedene Anlagenkonfigurationen vorgeschlagen.

Beispielsweise gibt die EP 0 277 536 A1 eine typische Inline-Anordnung an, d. h. eine Reihenschaltung verschiedener Beschichtungskammern. Die Substrate werden von einer Prozesskammer in die nächste mittels eines Transportsystems transportiert.

Eine Alternative dazu bieten sog. Cluster-Anordnungen, wie beispielsweise in der US 5,102,495 offenbart. Bei derartigen Anordnungen sind die Prozesskammern, in denen gleiche oder unterschiedliche Prozesse ablaufen können, von der zentralen Transportkammer aus wahlweise zugänglich. Das Einbringen von Substraten in die Prozesskammern und das Herausnehmen von Substraten aus den Prozesskammern erfolgt in der Regel nach einem vorgegebenen zeitlichen Ablaufschema. Auch bei dieser Anlagenform werden die Schichten eines Mehrschichtsystems sequentiell hintereinander auf dem Substrat abgeschieden.

Bei der Inline-Anlagenkonfigurationen bestimmt bei in etwa gleich bleibender Rate und sequentieller Beschichtung die dickste Schicht die Zykluszeit des gesamten Systems. Damit führt bereits eine einzige "lange" Beschichtungszeit für eine der Schichten zu insgesamt langen Zykluszeiten, z.B. von 90 bis 120 Sekunden für eine übliche TFT-Metallisierung. Beschichtungskammern mit kürzeren Beschichtungszeiten werden dagegen nicht ausgelastet, es entsteht ein "Stau" vor der Kammer mit der längsten Beschichtungszeit.

Aus der US 2005/0208731 ist ein Verfahren zur Herstellung einer integrierten Halbleiterschaltung mit dünnen Oxidschichten bekannt. Die dort offenbarte Anordnung kombiniert eine Cluster-Anordnung zur Oxidbeschichtung mit einer vorgeschalteten linearen Reinigungsstrasse zur Säuberung der Halbleiterwafer. Die Behandlung des Substrates geschieht unter Umgebungsdruck in Schutzgasatmosphäre.

Aus der EP 1 315 732 A1 ist bekannt, einer Clusteranlage zur Beschichtung von Substraten eine Abschlusskammer nachzulagern. Dabei dient eine Ladekammer sowohl zur Beschichtung einer zentralen Transportkammer als auch zur Beschickung der Abschlusskammer.

In herkömmlichen Clusteranlagen können zwar parallel mehrere - gleiche oder verschiedene - Prozesse ausgeführt werden. Allerdings ist die Wahl des Zeitfensters für unterschiedlich lange Prozesse einerseits durch die Auslastung des Transport-und Verteilungssystems zur die Verteilung der Substrate auf die Prozesskammern beschränkt. Werden beispielsweise die Substrate durch ein Drehmodul auf die Kammern verteilt, so stellt auch das "Drehen auf dem Drehmodul" einen Verfahrensschritt dar, für den Zeit benötigt wird. Insbesondere kann es zu Überschneidungen bei der Belegung des Drehmoduls im Hinblick auf einen optimalen zeitlichen Ablauf kommen. Zudem können Überschneidungen bei der Kammerbelegung auftreten.

Insgesamt bleibt festzuhalten, dass bei einer Clusteranordnung Überschneidungen bei der Belegung des Verteilungssystems Wartezeiten zur Folge haben können, was sich auf die Zykluszeiten negativ auswirkt.

Ausgehend davon ist es die Aufgabe der vorliegenden Erfindung, eine Anlage zur Behandlung von Substraten sowie ein Verfahren zur Behandlung von Substraten bereit zu stellen, mit deren Hilfe die Zykluszeit zur Herstellung von Mehrschichtsystemen insgesamt verringert werden kann.

Diese Aufgabe wird gelöst durch eine Anlage zur Behandlung von Substraten gemäß Anspruch 1 und ein Verfahren zur Behandlung von Substraten gemäß Anspruch 9.

Die erfindungsgemäße Anlage zum Behandeln von Substraten umfasst wenigstens eine erste Prozesskammer, eine zweite Prozesskammer und eine dritte Prozesskammer zum Behandeln eines Substrats. Wenigstens diese drei Prozesskammern sind an eine zentrale Transportkammer angeschlossen. Ferner ist ein erster Schleusenbereich zum Ein- oder Ausschleusen der Substrate in die Anlage bzw. aus der Anlage vorgesehen. Die erste Prozesskammer ist zwischen dem ersten Schleusenbereich und der zentralen Transportkammer in Reihe mit dem ersten Schleusenbereich und der zentralen Transportkammer angeordnet. Die zweite Prozesskammer und die dritte Prozesskammer sind unabhängig voneinander zugänglich, also parallel, an die zentrale Transportkammer angeschlossen. Ferner weist die Anlage eine vierte Prozesskammer auf, die an die zentrale Transportkammer angeschlossen ist, wobei die vierte Prozesskammer zwischen einem zweiten Schleusenbereich und der zentralen Transportkammer in Reihe mit dem zweiten Schleusenbereich und der zentralen Transportkammer angeordnet ist. Die drei genannten Prozesskammern sind im Prinzip um die zentrale Transportkammer herum angeordnet. Mehrere oder bevorzugt alle benachbarten Kammern können durch Ventiltüren oder -klappen gegeneinander verschlossen werden. Die Anlage weist einen zweiten Schleusenbereich zum Ausschleusen der Substrate aus der Anlage auf. Der zweite Schleusenbereich kann entweder direkt oder indirekt, d.h. mit weiteren dazwischen geschalteten Kammern, an die zentrale Transportkammer angeschlossen sein.

Durch die erfindungsgemäße Anordnung wird eine Kombination aus einer parallelen und einer seriellen Anordnung realisiert. Die serielle Anordnung des ersten Schleusenbereichs, der ersten Prozesskammer und der zentralen Transportkammer bedeutet, dass das Substrat auf einer Seite vom Schleusenbereich kommend über eine erste Öffnung in die erste Prozesskammer transportiert wird. Nach dem ersten Behandlungsschritt, beispielsweise dem Aufbringen einer ersten Schicht auf das Substrat, wird das Substrat aus der ersten Prozesskammer über eine zweite Öffnung in die zentrale Transportkammer gefördert. Es wird somit im Betrieb der Anlage ein Substrat nach dem anderen in gleicher Richtung durch die erste Prozesskammer hindurchgeschleust. Jedes der Substrate erhält in der ersten Prozesskammer eine erste Behandlung, beispielsweise eine erste Beschichtung.

Die Erfindung umfasst sämtliche Anordnungen aus einer Kombination zwischen Inline- und Cluster-Anordnung. Dies bedeutet, dass die Kammern in der beanspruchten Konfiguration direkt, beispielsweise über Ventile, aneinander angeschlossen sein können. Es könnten jedoch beispielsweise zwischen dem Schleusenbereich und der ersten Behandlungskammer weitere Behandlungskammern angeordnet werden, je nachdem, welche Behandlung durchgeführt werden soll, beispielsweise welches, Schichtsystem hergestellt werden soll.

Erfindungsgemäß sind die zweite und die dritte Prozesskammer _{"}parallel" an der zentralen Transportkammer angeschlossen. "Parallel" bedeutet dabei nicht unbedingt eine parallele Ausrichtung der Prozesskammern im geometrischen Sinn. Vielmehr bedeutet eine parallele Anordnung, dass die beiden Prozesskammern jeweils an die zentrale Transportkammer angeschlossen und von der zentralen Transportkammer aus über jeweils eine Öffnung parallel und selektiv zugänglich sind. Die zweite und die dritte Kammer sind also nicht in Reihe zueinander angeordnet.

Ein von der ersten Prozesskammer in die zentrale Transportkammer transportiertes Substrat kann demnach wahlweise in der zweiten oder dritten Prozesskammer weiter bearbeitet werden. Während die erste Prozesskammer von jedem der durch die Anlage geschleusten Substrate durchlaufen wird, können die zweite und die dritte Prozesskammer im laufenden Betrieb beispielsweise abwechselnd mit Substraten aus der ersten Prozesskammer über die zentrale Transportkammer beschickt werden. Es versteht sich von selbst, dass die Anzahl der parallel an die zentrale Transportkammer angeschlossenen Prozesskammern nicht auf zwei beschränkt sein muss. Ihre Anzahl hängt in erster Linie von den für die einzelnen Behandlungsschritte benötigten Behandlungszeiten ab.

Es sei an dieser Stelle angemerkt, dass die Erfindung im Wesentlichen auf die Konfiguration der einzelnen Prozesskammern gerichtet sein soll. Im Hauptanwendungsfall fall sollen dabei die Prozesskammern Beschichtungskammern, insbesondere Sputterkammern, zum Auftragen mehrerer Metallschichten auf ein Substrat mittels Sputtern sein. In einer anderen Ausführungsform können jedoch die Prozesskammern auch für alternative Prozesse der Oberflächenbehandlung, beispielsweise Ätzen, oder für andere Prozesse zur Schichtbildung, beispielsweise für CVD-Beschichtung, vorgesehen sein.

Im Vergleich zu herkömmlichen Clusteranlagen ergibt sich der Vorteil eines optimalen Zeitablaufs des Gesamtprozesses inklusive Transportsystem und Drehmodulbelegung. Zeitliche Überschneidungen der Kammerbelegung werden vermieden, so dass keine Wartezeiten auftreten.

Die Anlage umfasst außerdem eine vierte Prozesskammer, die an die zentrale Transportkammer angeschlossen ist, wobei die vierte Prozesskammer zwischen der zentralen Transportkammer und dem zweiten Schleusenbereich in Reihe angeordnet ist. Mittels der vierten Prozesskammer wird die erfindungsgemäße Anlage also um eine weitere Inline-Komponente erweitert. Ein Substrat durchläuft in dieser erweiterten Anlagenkonfiguration die erste Behandlungskammer zur Durchführung eines ersten Behandlungsschritts, beispielsweise zum Aufbringen einer ersten Schicht auf das Substrat, die zweite oder dritte Behandlungskammer zur Durchführung eines zweiten Behandlungsschritts, beispielsweise zum Aufbringen einer zweiten (in der Regel dickeren) Schicht, und anschließend die vierte Behandlungskammer zur Durchführung eines dritten Behandlungsschritts, beispielsweise zum Aufbringen einer dritten Schicht (die in der Regel dünner ist als die zweite Schicht). Die vierte Prozesskammer kann direkt oder indirekt mit dem zweiten Schleusenbereich und/oder der zentralen Transportkammer verbunden sein. Wichtig ist die Tatsache, dass die drei Kammern (zentrale Transportkammer, vierte Prozesskammer und Schleusenkammer) in Reihe miteinander verbunden sind, d. h. dass sämtliche zu prozessierende Substrate die vierte Prozesskammer in der gleichen Richtung durchlaufen.

Insbesondere umfasst die Anlage Transportmittel zum Transport der Substrate durch die Anlage vom ersten Schleusenbereich in die erste Prozesskammer zur Durchführung eines ersten Behandlungsschritts, beispielsweise zum Aufbringen einer ersten Schicht auf das Substrat, zum Transport von der ersten Prozesskammer in die zentrale Transportkammer, zum Transport von der zentralen Transportkammer wahlweise in die zweite oder dritte Prozesskammer zur Durchführung eines zweiten Behandlungsschritts, beispielsweise zum Aufbringen einer zweiten Schicht auf das Substrat, und zum Rücktransport von der zweiten bzw. dritten Prozesskammer in die zentrale Transportkammer. In der zentralen Transportkammer wird jedes Substrat entweder in die zweite oder in die dritte Prozesskammer transportiert. Dazu können die Transportmittel eine Drehplattform in der zentralen Transportkammer aufweisen, die zum Beschicken der zweiten oder dritten Prozesskammer bzw. zur Aufnahme eines Substrats aus der zweiten oder dritten Prozesskammer durch - Rotation um eine vertikale Achse ausgerichtet werden kann. Besonders vorteilhaft ist eine Anlage, bei der die Substrate während des Transports durch die Anlage undwährend ihrer Prozessierung im Wesentlichen vertikal angeordnet sind. Eine im Wesentlichen vertikale Ausrichtung soll auch eine Ausrichtung der Substrate mit einer Neigung bis zu 5° oder bis zu 10° zur Senkrechten einschließen..

Vorzugsweise weist die zentrale Transportkammer eine Drehplattform zum Ausrichten der Substrate wahlweise zur Öffnung der zweiten Prozesskammer oder zur Öffnung der dritten Prozesskammer zum Transportieren der Substrate wahlweise in die zweite oder dritte Prozesskammer und zur Aufnahme der Substrate aus der zweiten bzw. der dritten Prozesskammer auf. Somit ist ein sequentielles Einbringen der Substrate, beispielsweise abwechselnd in die zweite und dritte Prozesskammer, möglich. Die Substrate können bei der erfindungsgemäßen Anlagenkonfiguration in der zweiten und dritten Prozesskammer zeitlich überlappend bearbeitet werden.

Benachbarte Kammern, insbesondere sämtliche benachbarte Kammern, können durch Ventiltüren gegeneinander verschließbar sein. Dadurch, dass alle benachbarten Kammern durch Ventile vakuumdicht gegen einander verschließbar sind, können unterschiedliche Prozesse wie PECVD oder Ätzen in einer der Prozesskammern durchgeführt werden, ohne dass die dazu benötigten Prozessgase die benachbarten Sputterprozesse während der Prozessdauer negativ beeinflussen können.

In einer besonderen Ausführungsform ist die erste Prozesskammer zur Durchführung eines ersten Behandlungsschritts, beispielsweise eines ersten Beschichtungsprozesses eingerichtet, und die zweite und die dritte Prozesskammer sind zur Durchführung eines zweiten Behandlungsschritts, beispielsweise zur Durchführung eines zweiten Beschichtungsprozesses, eingerichtet. In der Regel wird jedes Substrat einen ersten kürzeren Prozess und einen zweiten länger dauernden Prozess durchlaufen, beispielsweise wird jedes Substrat eine dünnere erste Schicht und eine dickere zweite Schicht erhalten. Die dickere zweite Schicht erhält jedes Substrat alternativ in der zweiten oder dritten Prozesskammer. Die erfindungsgemäße Anlagenkonfiguration ist also insbesondere vorteilhaft, wenn der zweite Prozess länger dauert als der erste. Durch die alternative Auswahl der zweiten oder dritten Behandlungskammer für den zweiten Prozess können wenigstens zwei Substrate zeitüberlappend behandelt werden. Auf diese Weise wird die gesamte Zykluszeit verringert.

Die Prozesszeiten für die in der ersten und vierten Prozesskammer durchgeführten Prozesse sind vorzugsweise kürzer als die Prozesszeiten für die in der zweiten und dritten Prozesskammer durchgeführten Prozesse. Insbesondere wird angestrebt, dass die Prozesszeiten in der ersten und vierten Kammer nicht zu stark voneinander abweichen, da sie ,,in line" ablaufen.

In einer besonderen Ausführungsform ist die Anlage zur Ausbildung einer TFT-(Thin Film Transistor)-Metallisierung ausgebildet, wobei eine der Schichten in der Schichtfolge alternativ in der zweiten Prozesskammer oder in der dritten Prozesskammer aufgebracht wird.

In einer besonderen Ausführungsform umfassen der erste Schleusenbereich und/oder der zweite Schleusenbereich jeweils eine Schleusenkammer und eine Transferkammer.

Die erfindungsgemäße Aufgabe wird auch gelöst durch ein Verfahren zur Behandlung von Substraten, insbesondere zur Durchführung des Verfahrens in einer Anlage wie oben beschrieben, umfassend die Schritte: a) Einschleusen eines Substrats in die Anlage; b) Transportieren des Substrats in eine erste Prozesskammer, die zwischen einem ersten Schleusenbereich und einer zentralen Transportkammer in Reihe mit dem ersten Schleusenbereich und der zentralen Transportkammer angeordnet istund Durchführung eines ersten Behandlungsschritts (beispielsweise Aufbringen einer ersten Schicht auf das Substrat); c) Transportieren des Substrats in die zentrale Transportkammer; d) Transportieren des Substrats alternativ in die zweite oder die dritte Prozesskammer; und Durchführung eines zweiten Behandlungsschritts (beispielsweise Aufbringen einer zweiten Schicht auf das Substrat); e) Rücktransport des Substrats in die zentrale Transportkammer; f) Transportieren des Substrats in eine vierte Prozesskammer, welche zwischen einem zweiten Schleusenbereich und der zentralen Transportkammer in Reihe mit dem zweiten Schleusenbereich und der zentralen Transportkammer angeordnet ist und Durchführen eines weiteren Behandlungsschritts; und g) Ausschleusen des Substrats aus der Anlage.

Auch aus den Verfahrensschritten wird die Grundidee der Erfindung deutlich. Zunächst wird das Substrat "inline" von einem Einschleusbereich in eine erste Prozesskammer und von dort weiter in eine zentrale Transportkammer transportiert. Durch das Bereitstellen einer zweiten und dritten Prozess- bzw. Beschichtungskammer, die "parallel" an die zentrale Transportkammer angeschlossen sind, wird eine alternative Auswahlmöglichkeit geschaffen, den weiteren Behandlungsschritt, beispielsweise das Aufbringen einer weiteren Schicht, alternativ in der zweiten oder dritten Prozesskammer durchzuführen. Dies bedeutet, dass der zweite Behand lungsschritt in der zweiten und dritten Prozesskammer teilweise zeitüberlappend durchgeführt werden kann. D.h. dass bei Beschichtungsprozessen die weitere Schicht auf wenigstens zwei Substrate in der zweiten und dritten Prozesskammer teilweise zeitüberlappend aufgebracht werden kann.

Im Rahmen der Erfindung soll es auch möglich sein, die erste Prozesskammer - statt in Reihe mit einem Einschleusbereich und der zentralen Prozesskammer - in Reihe mit der zentralen Transportkammer und einem Ausschleusbereich anzuordnen. In diesem Fall wäre der Verfahrensschritt b) "Transportieren des Substrats in die erste Prozesskammer und Durchführen eines Behandlungsschritts (beispielsweise Aufbringen einer Schicht auf das Substrat) zwischen den Verfahrensschritten e) und f) einzuordnen. Die im Schritt d) aufgebrachte Schicht läge dann selbstverständlich unterhalb der im Schritt b) aufgebrachten Schicht.

Der Schritt f) beinhaltet das Transportieren des Substrats in die vierte Prozesskammer und das Durchführen eines dritten Behandlungsschritts (beispielsweise Aufbringen einer dritten Beschichtung auf das Substrat). Diese erweiterte Methode ist insbesondere vorteilhaft, wenn ein Schichtsystem aus wenigstens einer ersten und dritten dünnen Schicht, und einer dazwischen liegenden zweiten dickeren Schicht hergestellt werden soll. Da in diesem Fall die Zykluszeit für das Abscheiden der dickeren Schicht länger ist (beispielsweise doppelt so lang wie für die dünneren Schichten), wird bei Inline- oder reinen Cluster-Anlagen, in denen die Schichten sequentiell abgeschieden werden, die Zykluszeit durch den zweiten Beschichtungsschritt bestimmt. Mit dem vorliegenden Verfahren kann die Zykluszeit insgesamt dadurch reduziert werden, dass die dickere Schicht wenigstens teilweise zeitüberlappend auf zwei hintereinander in die Anlage eingeschleuste Substrate aufgebracht werden kann. Es wird also eine sequentielle (für die erste und dritte Schicht) sowie eine parallele Beschichtung (für die zweite Schicht) in einer Anlage realisiert. Gleiches gilt für andere unterschiedlich lang dauernde Behandlungsschritte.

Für die erste und die dritte Behandlung bzw. die erste und dritte Schicht ist die Anlage als Inline-Anlage konfiguriert. Für diese Behandlungen bzw. Schichten gilt jeweils, dass die Behandlungszeit der Zykluszeit abzüglich der Fahrtzeit entspricht. Für die zweite Behandlung sind zwei parallel angeordnete (d. h. zwei parallel von der zentralen Transportkammer zugängliche) Behandlungs- bzw. Beschichtungsstationen vorgesehen. Diese werden in jedem zweiten Zyklus abwechselnd mit dem aus der ersten Prozesskammer in die zentrale Transportkammer transportierten Substrat belegt. Damit entspricht die Behandlungszeit für das Durchführen des zweiten Behandlungsschritts bzw. für das Aufbringen der zweiten Schicht etwa der doppelten Zykluszeit abzüglich der Fahrtzeit.

In einer besonderen Ausführungsform erfolgt das Einschleusen des Substrats in die Anlage durch eine Einschleuskammer und eine Transferkammer.

Insbesondere kann in der zweiten und dritten Prozesskammer der gleiche Prozess ablaufen. Dieser Prozess wird in der Regel jeweils länger dauern als die in der ersten und gegebenenfalls der vierten Prozesskammer ablaufenden Prozesse.

Die Behandlungszeiten der in der ersten und vierten Prozesskammer ablaufenden Prozesse sollten kürzer als die in der zweiten und dritten Kammer sein. Außerdem sollten die Behandlungszeiten in der ersten und vierten Kammer aneinander angepasst sein.

Insbesondere werden durch den erfindungsgemäßen Prozess wenigstens drei Schichten zur TFT-Metallisierung aufgebracht.

Während des Transports durch die Anlage sind die Substrate bevorzugt im Wesentlichen vertikal, d.h. senkrecht oder mit einer relativ geringen Neigung von bis zu 5° oder 10° zur Senkrechten geneigt, ausgerichtet. Auf diese Weise können platzsparend auch größere Substrate beschichtet werden.

Insbesondere wird das erfindungsgemäße Verfahren sequentiell zeitlich versetzt mit wenigstens einem zweiten Substrat S wiederholt. Dabei werden bestimmte Verfahrensschritte, speziell die zweite Metallisierung (z.B. Al), zeitlich überlappend an den beiden Substraten durchgeführt. Dies bedeutet, dass in der Anlage, am Beispiel von zwei Substraten, folgendes Verfahren ablaufen kann:
- Zeitpunkt 1:: Substrat 1: Verfahrensschritt a);
- Zeitpunkt 2:: Substrat 1: Verfahrensschritt b), Substrat 2: Verfahrensschritt a);
- Zeitpunkt 3:: Substrat 1: Verfahrensschritt c), Substrat 2: Verfahrensschritt b);
- Zeitpunkt 4:: Substrat 1: Verfahrensschritt d) in der zweiten Prozesskammer, Substrat 2: Verfahrensschritt c);
- Zeitpunkt 5:: Substrat 1: Fortsetzung des Verfahrensschritts d) in der zweiten Prozesskammer, Substrat 2: Verfahrensschritt d) in der dritten Prozesskammer;
- Zeitpunkt 6:: Substrat 1: Verfahrensschritt e), Substrat 2: Fortsetzung des Verfahrensschritts d) in der dritten Prozesskammer;
- Zeitpunkt 7:: Substrat 1: Verfahrensschritt f), Substrat 2: Verfahrensschritt e);
- Zeitpunkt 8:: Substrat 1: Verfahrensschritt g), Substrat 2: Verfahrensschritt f)
- Zeitpunkt 9:: Substrat 1: ausgeschleust, Substrat 2: Verfahrensschritt g).

Selbstverständlich können dem zweiten Substrat sequenziell weitere Substrate folgen. Aus diesem Beispiel wird anschaulich, dass mit dem erfindungsgemäßen Verfahren die Zykluszeit reduziert werden kann. Insbesondere findet im Verfahrensschritt 5 beim Aufbringen der zweiten Schicht eine zeitlich überlappende Bearbeitung der Substrate statt.

Weitere Merkmale und Vorteile der Erfindung ergeben sich aus der Beschreibung spezieller Ausführungsbeispiele. Es zeigen die
- Figur 1: eine erfindungsgemäße Behandlungsanlage; und
- Figur 2: eine alternative Ausführungsform der erfindungsgemäßen Anlage.

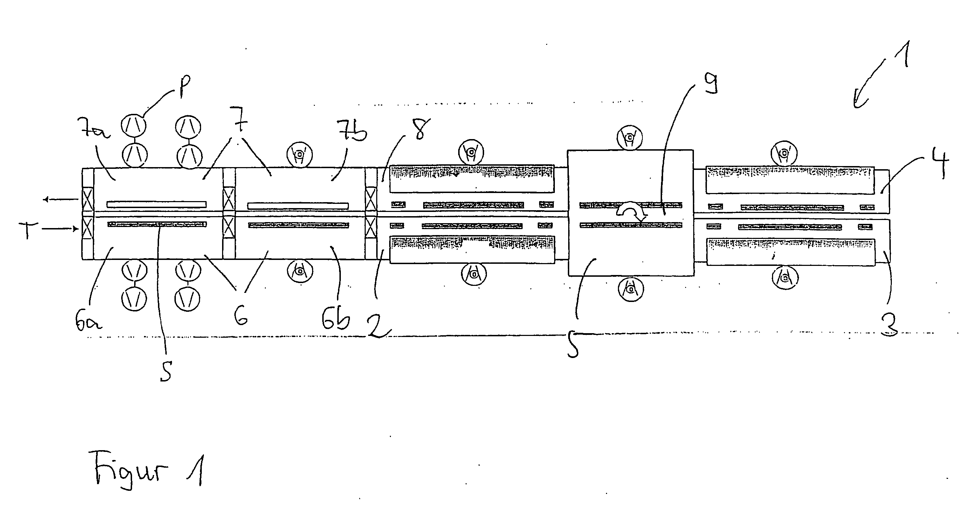

In der Figur 1 ist eine Anlage 1 zum Beschichten von Substraten S dargestellt. Die Anlage 1 umfasst übliche Komponenten, wie z.B. ein Pumpensystem, angedeutet durch den Buchstaben P zur Bezeichnung eines Pumpensymbols.

Die dargestellte Beschichtungsanlage 1 weist eine Anordnung von Kammern bzw. Stationen 2, 3, 4, 5, 6, 7 und 8 auf. Insgesamt sind Beschichtungsstationen 2, 3, 4 und 8 vorgesehen. Daneben umfasst die Anlage einen Einschleusbereich 6 und einen Ausschleusbereich 7 sowie eine zentrale Transportkammer 5.

Die erste Beschichtungskammer 2 ist zwischen der Einschleusstation 6 und der zentralen Transportkammer 5 und mit diesen beiden Kammern in Reihe (,,in line") angeordnet. Die vierte Beschichtungskammer 8 ist zwischen der zentralen Transportkammer 5 und der Ausschleusstation 7 in Reihe ("in line") mit diesen angeordnet. In der ersten und vierten Beschichtungskammer 2, 8 wird vorzugsweise eine Metallisierung, beispielsweise mit Ti (Titan) oder Mo (Molybdän) durchgeführt. Dabei kann in den beiden Kammern 2 und 8 das gleiche oder unterschiedliches Material mit vorgegebenen Schichtdicken aufgebracht werden.

Die Beschichtungskammern 3 und 4 hingegen sind parallel angeordnet. Dies bedeutet, dass ein Substrat S die Kammern 3 bzw. 4 nicht in einer Richtung durchläuft, sondern, wie bei einer Clusteranlage, die Substrate S von der zentralen Transportkammer 5 alternativ und wahlweise in eine der Beschichtungskammern 3 und 4 transportiert, dort prozessiert, und anschließend wieder in die zentrale Transportkammer 5 zurücktransportiert werden. Bevorzugt wird in der zweiten oder dritten Beschichtungskammer eine weitere Metallisierung auf die erste Metallisierung aufgebracht, beispielsweise (aber nicht beschränkt auf) A1 (Aluminium).

Die dargestellte Anlage 1 ist somit eine kombinierte Inline-Cluster-Konfiguration, mit deren Hilfe die Zykluszeit für die sequentielle Prozessierung mehrerer Substrate verringert werden kann.

Insbesondere ist die Anlage 1 für eine TFT-Metallisierung konzipiert.

Die Substrate S werden zunächst über die Einschleusstation 6 in die Anlage 1 eingeschleust. Die Einschleusstation 6 besteht im vorliegenden Fall aus einer Einschleuskammer 6a und einer Transferkammer 6b.

In der ersten Beschichtungskammer 2 werden die Substrate S mittels Sputtern mit einer ersten Schicht beschichtet. Die nacheinender in die Anlage 1 eingeschleusten mit der ersten Schicht beschichteten Substrate S werden in der zweiten oder dritten Beschichtungskammer 3 oder 4 alternativ und abwechselnd mittels Sputtern mit einer zweiten Schicht (z.B. Al) versehen. In der vierten Beschichtungsstation 8 wird mittels Sputtern eine weitere Schicht auf die zweite Schicht aufgebracht. Den zuletzt genannten Verfahrensschritt durchlaufen die Substrate S wiederum nacheinander und zeitlich getrennt. Die Prozesszeiten der in den Beschichtungsstationen 2 und 8 ablaufenden Behandlungsschritte sollten aufeinander abgestimmt und in etwa gleich lange gewählt werden.

Die Ausschleusung aus der Anlage 1 erfolgt über die Ausschleusstation 7, die sich an die vierte Beschichtungskammer 8 anschließt. Die Ausschleusstation 7 umfasst im vorliegenden Fall eine Ausschleuskammer 7a und eine zwischen der Ausschleuskammer 7a und der vierten Beschichtungskammer 8 angeordnete Transferkammer 7b.

Die zentrale Transportkammer 5 dient im Wesentlichen dazu, Substrate S aus der ersten Beschichtungskammer 2 nacheinander aufzunehmen, und diese anschließend abwechselnd in die zweite Beschichtungskammer 3 oder, alternativ, in die dritte Beschichtungskammer 4 weiter zu transportieren. Dazu werden die Substrate S auf einer Drehplattform 9 aufgenommen und durch die Drehplattform 9 in der zentralen Transportkammer 5 gegenüber der Öffnung zur zweiten Kammer 3 oder zur dritten Kammer 4 ausgerichtet.

Die zweite Beschichtungskammer 3 und die dritte Beschichtungskammer 4 sind beide unmittelbar an die zentrale Transportkammer 5 angeschlossen und ermöglichen somit einen parallelen bzw. wahlweisen Zugriff auf die beiden Kammern 3 und 4.

Von der Plattform 9 wird das Substrat S in die zweite oder dritte Kammer 3 oder 4 transportiert. Nach der Prozessierung in der zweiten oder dritten Kammer 3 oder 4 wird das behandelte Substrat S wiederum auf der Plattform 9 aufgenommen. Das Substrat S wird mittels der Plattform 9 gegenüber der Öffnung zur vierten Beschichtungskammer 8 hin ausgerichtet, so dass der Transport in die vierte Beschichtungskammer 8 mit einer anschließenden dritten Beschichtung erfolgen kann.

Da die zweite Schicht wesentlich dicker als die erste und die dritte Schicht ist, dauert der Prozess im Verhältnis wesentlich länger. Um jedoch die gesamte Zykluszeit, die in herkömmlichen "in-line"-Anlagen durch den langsamsten Prozessschritt bestimmt wird, zu reduzieren, sind die beiden parallelen Beschichtungsstationen 3 und 4 vorgesehen, in denen sequentiell aufeinander folgende Substrate S wenigstens teilweise zeitüberlappend dem gleichen Prozess unterworfen werden. Im Vergleich zu herkömmlichen Clusteranlagen ergibt sich der Vorteil eines optimalen Zeitablaufs des Gesamtprozesses inklusive Transportsystem und Drehmodulbelegung. Überschneidungen der Kammerbelegung werden vermieden, so dass keine Wartezeiten auftreten.

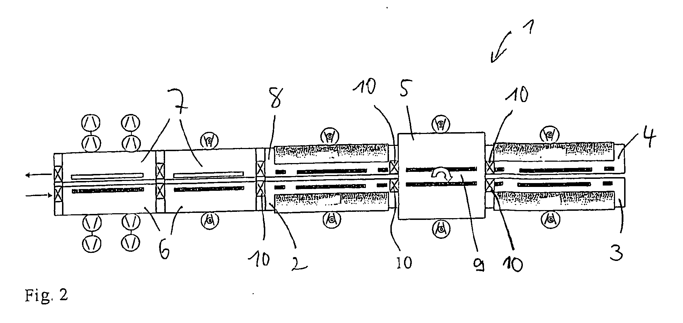

Eine alternative Ausführungsform zeigt die Figur 2. Die Anlage entspricht im Wesentlichen der in der Figur 1 gezeigten Anlage, wobei gleiche Komponenten mit gleichen Bezugszeichen gekennzeichnet sind. Zusätzlich sind in dieser Ausführungsform sämtliche benachbarte Kammern, also insbesondere auch die Kammern 2 und 5, 5 und 3, 5 und 4, 5 und 8, durch Ventiltüren 10 vakuumdicht gegeneinander verschließbar. Dadurch können in den Prozesskammern 2, 3, 4, und 8 unterschiedliche Prozesse wie PECVD oder Ätzen in einer Anlage durchgeführt werden. Durch die Ventile wird verhindert, dass die zu den unterschiedlichen Prozessen benötigten Prozessgase in die benachbarte Kammer gelangt und den dort ablaufenden Prozess negativ beeinflusst.

Der zeitliche Ablauf des Prozesses innerhalb der Beschichtungsanlage 1 wird aus der folgenden Tabelle 1 deutlich, wobei die Nummer des Substrats S der Reihenfolge der Einschleusung entspricht, tx einen bestimmten Zeittakt, und die Nummern in der Tabelle den Ort (entsprechend den Bezugszeichen der Figur) eines bestimmten Substrats S zu einem bestimmten Zeitpunkt tx angeben. "5-in" bedeutet bespielhaft, dass im Zeittakt tx ein Transport in die Kammer 5 erfolgt.

**Tabelle 1**

| | Substrat Nr. | | |
|---|---|---|---|
| t | 1 | 2 | 3 |
| t1 | 6a-in | | |
| t2 | 6a | | |
| t3 | 6b-in | | |
| t4 | 6b | | |
| t5 | 6b | 6a-in | |
| t6 | 2-in | 6a | |
| t7 | 2 | 6b-in | |
| t8 | 2 | 6b | |
| t9 | 5-in, 3-in | 6b | 6a-in |
| t10 | 3 | 2-in | 6a |
| t11 | 3 | 2 | 6b-in |
| t12 | 3 | 2 | 6b |
| t13 | 3 | 5-in | 6b |
| t14 | 3 | Drehen der Plattform, 4-in | 2-in |
| t15 | 5-in | 4 | 2 |
| t16 | Drehen der Plattform, 8-in | 4 | 2 |
| t17 | 8 | 4 | 5-in, 3-in |
| t18 | 8 | 4 | 3 |
| t19 | 7b-in | 4 | 3 |
| t20 | 7b | 5-in, 8-in | 3 |
| t21 | 7b | 8 | 3 |
| t22 | 7a-in | 8 | 3 |
| t23 | AUS | 7b-in | 5-in |
| t24 | | 7b | Drehen der Plattform, 8-in |
| t25 | | 7b | 8 |
| t26 | | 7a-in | 8 |
| t27 | | AUS | 7b-in |
| t28 | | | 7b |
| t29 | | | 7b |
| t30 | | | 7a-in |
| t31 | | | AUS |

Zur weiteren Verdeutlichung des erfindungsgemäßen Verfahrens sind in den folgenden Tabellen 2 und 3 Verfahrenszyklen für die Behandlung von vier Substraten a) in einer herkömmlichen Cluster-Anlage (Tabelle 2), und b) in der erfindungsgemäßen kombinierten Inline-Cluster-Anlage (Tabelle 3) im Vergleich dargestellt.

Ein Beschichtungszyklus setzt sich jeweils aus Einschleusen, Beschichten mit einer ersten Schicht in einer ersten Kammer, Beschichten mit einer zweiten Schicht in einer zweiten oder einer dritten Kammer, und Beschichten mit einer dritten Schicht in einer vierten Kammer zusammen. Dabei benötigt man für den Prozessschritt "Beschichtung 1" drei Zeiteinheiten, für den Prozessschritt "Beschichtung 2" sechs Zeiteinheiten, und für den Prozessschritt "Beschichtung 3" wiederum drei Zeiteinheiten. Der Einsatz des Drehmoduls in der zentralen Verteilungsstation (zentrale Transferkammer) erfordert eine Zeiteinheit. Jedes Substrat durchläuft die Beschichtungsstationen 1, alternativ 2 oder 3, und 4 in dieser Reihenfolge. Der Begriff "Drehmodul" bedeutet, dass ein Substrat entweder über das Drehmodul transportiert wird oder auf das Drehmodul gefahren und durch eine Drehung in eine alternative Position gebracht und danach in die Zielkammer transportiert wird.

Die Tabelle 2 bezieht sich auf eine herkömmliche Cluster-Anordnung mit den Beschichtungsstationen 1 bis 4, die um eine zentrale Transferkammer (mit einem Drehmodul) angeordnet sind. Ebenso sind die Einschleus- und die Ausschleusstation an die zentrale Transferkammer angeschlossen.

Wie aus der Tabelle 2 hervorgeht, benötigt man für die Prozessierung der vier Substrate insgesamt 35 Zeiteinheiten. Aufgrund der Besetzung bestimmter Kammern bzw. des Drehmoduls zu bestimmten Zeitpunkten kann es im Bearbeitungsablauf zu Zeitverzögerungen kommen. Beispielsweise kann das Substrat 4 zu den Zeittakten 17 und 18 nicht weiter prozessiert werden, da einmal die Kammer 1, im nächsten Zeittakt das Drehmodul besetzt ist. Das Substrat muss demnach "warten", bis die nächste Station frei ist. Durch die Kumulation einzelner Verzögerungen ergibt sich eine Gesamtverzögerung, die die gesamte Zykluszeit für die Prozessierung der vier Substrate bestimmt.

Die Tabelle 3 zeigt ebenfalls die Beschichtung von vier Substraten mit der gleichen Schichtfolge, d. h. mit den gleichen Beschichtungszeiten und Durchlaufzeiten durch die einzelnen Anlagenkomponenten in einer erfindungsgemäßen kombinierten Inline-Cluster-Anordnung wie in der Figur dargestellt.

Es zeigt sich, dass bei gleichen Prozesszeiten für die Prozessierung der vier Substrate lediglich 32 Zeittakte benötigt werden. Dies liegt in erster Linie daran, dass durch die Kombination der Anordnung der Kammern in Reihe und parallel das Drehmodul seltener benötigt wird. Auch Belegungen der Kammern durch Substrate, die nachfolgende Substrate in ihrer Prozessierung aufhalten, können bei der gezeigten Prozessfolge leichter vermieden werden. Außerdem kann Zeit auch dadurch eingespart werden, dass sich das Drehmodul nur bei jedem zweiten ankommenden Substrat tatsächlich drehen muss. Ansonsten läuft das Substrat lediglich direkt über das Drehmodul von einer Ausgangskammer in die Zielkammer. Darüber hinaus wird für den linearen Transport des Substrates S von der Schleusenkammer in die erste Prozesskammer bzw. von der vierten Prozesskammer in die Schleusenkammer zum Ausschleusen deutlich weniger Zeit benötigt, als für den Transport auf das Drehmodul, das Drehen bzw. Ausrichten des Moduls und das anschließende Befördern in die jeweilige Prozesskammer.

Insgesamt ergibt sich im Beispiel eine Zeitersparnis von drei Zeittakten für den beschriebenen Prozess. Wie groß die Zeitersparnis für verschiedene Prozesse tatsächlich ist, hängt entscheidend von den Zeitdauern der einzelnen Prozessierungs- und Transportschritte ab.

**Tabelle 2**

| **Clusteranlage:** | | | | |
|---|---|---|---|---|
| | **Substrat 1** | **Substrat 2** | **Substrat 3** | **Substrat 4** |
| **Zeittakt 1** | Einschleusen | | | |
| **Zeittakt 2** | Einschleusen | | | |
| **Zeittakt 3** | Einschleusen | | | |
| **Zeittakt 4** | Drehmodul | Einschleusen | | |
| **Zeittakt 5** | Beschichtung 1 in Kammer 1 | Einschleusen | | |
| **Zeittakt 6** | Beschichtung 1 in Kammer 1 | Einschleusen | | |
| **Zeittakt 7** | Beschichtung 1 in Kammer 1 | [Kammer 1 besetzt ==> warten in Schleuse] | [Schleuse besetzt] | |
| **Zeittakt 8** | Drehmodul | [Drehmodul besetzt ==> warten in Schleuse] | [Schleuse besetzt] | |
| **Zeittakt 9** | Beschichtung 2 in Kammer 2 | Drehmodul | Einschleusen | |
| **Zeittakt 10** | Beschichtung 2 in Kammer 2 | Beschichtung 1 in Kammer 1 | Einschleusen | |
| **Zeittakt 11** | Beschichtung 2 in Kammer 2 | Beschichtung 1 in Kammer 1 | Einschleusen | |
| **Zeittakt 12** | Beschichtung 2 in Kammer 2 | Beschichtung 1 in Kammer 1 | [Kammer 1 besetzt ==> warten in Schleuse] | [Schleuse besetzt] |
| **Zeittakt 13** | Beschichtung 2 in Kammer 2 | Drehmodul | [Drehmodul besetzt ==> warten in Schleuse] | [Schleuse besetzt] |
| **Zeittakt 14** | Beschichtung 2 in Kammer 2 | Beschichtung 2 in Kammer 3 | Drehmodul | Einschleusen |
| **Zeittakt 15** | Drehmodul | Beschichtung 2 in Kammer 3 | Beschichtung 1 in Kammer 1 | Einschleusen |
| **Zeittakt 16** | Beschichtung 3 in Kammer 4 | Beschichtung 2 in Kammer 3 | Beschichtung 1 in Kammer 1 | Einschleusen |
| **Zeittakt 17** | Beschichtung 3 in Kammer 4 | Beschichtung 2 in Kammer 3 | Beschichtung 1 in Kammer 1 | [Kammer 1 besetzt ==> warten in Schleuse] |
| **Zeittakt 18** | Beschichtung 3 in Kammer 4 | Beschichtung 2 in Kammer 3 | Drehmodul | [Drehmodul besetzt ==> warten in Schleuse] |
| **Zeittakt 19** | Drehmodul | Beschichtung 2 in Kammer 3 | Beschichtung 2 in Kammer 2 | Drehmodul |
| **Zeittakt 20** | Ausschleusen | Drehmodul | Beschichtung 2 in Kammer 2 | Beschichtung 1 in Kammer 1 |
| **Zeittakt 21** | | Beschichtung 3 in Kammer 4 | Beschichtung 2 in Kammer 2 | Beschichtung 1 in Kammer 1 |
| **Zeittakt 22** | | Beschichtung 3 in Kammer 4 | Beschichtung 2 in Kammer 2 | Beschichtung 1 in Kammer 1 |
| **Zeittakt 23** | | Beschichtung 3 in Kammer 4 | Beschichtung 2 in Kammer 2 | Drehmodul |
| **Zeittakt 24** | | Drehmodul | Beschichtung 2 in Kammer 2 | Beschichtung 2 in Kammer 3 |
| **Zeittakt 25** | | Ausschleusen | Drehmodul | Beschichtung 2 in Kammer 3 |
| **Zeittakt 26** | | | Beschichtung 3 in Kammer 4 | Beschichtung 2 in Kammer 3 |
| **Zeittakt 27** | | | Beschichtung 3 in Kammer 4 | Beschichtung 2 in Kammer 3 |
| **Zeittakt 28** | | | Beschichtung 3 in Kammer 4 | Beschichtung 2 in Kammer 3 |
| **Zeittakt 29** | | | Drehmodul | Beschichtung 2 in Kammer 3 |
| **Zeittakt 30** | | | Ausschleusen | Drehmodul |
| **Zeittakt 31** | | | | Beschichtung 3 in Kammer 4 |
| **Zeittakt 32** | | | | Beschichtung 3 in Kammer 4 |
| **Zeittakt 33** | | | | Beschichtung 3 in Kammer 4 |
| **Zeittakt 34** | | | | Drehmodul |
| **Zeittakt 35** | | | | Ausschleusen |

**Tabelle 3**

| **Kobinierte Inline-Cluster-Anlage:** | | | | |
|---|---|---|---|---|
| | **Substrat 1** | **Substrat 2** | **Substrat 3** | **Substrat 4** |
| **Zeittakt 1** | Einschleusen | | | |
| **Zeittakt 2** | Einschleusen | | | |
| **Zeittakt 3** | Einschleusen | | | |
| **Zeittakt 4** | Transport in Kammer 1 | | | |
| **Zeittakt 5** | Beschichtung 1 in Kammer 1 | Einschleusen | | |
| **Zeittakt 6** | Beschichtung 1 in Kammer 1 | Einschleusen | | |
| **Zeittakt 7** | Beschichtung 1 in Kammer 1 | Einschleusen | | |
| **Zeittakt 8** | Drehmodul | Transport in Kammer 1 | | |
| **Zeittakt 9** | Beschichtung 2 in Kammer 2 | Beschichtung 1 in Kammer 1 | Einschleusen | |
| **Zeittakt 10** | Beschichtung 2 in Kammer 2 | Beschichtung 1 in Kammer 1 | Einschleusen | |
| **Zeittakt 11** | Beschichtung 2 in Kammer 2 | Beschichtung 1 in Kammer 1 | Einschleusen | |
| **Zeittakt 12** | Beschichtung 2 in Kammer 2 | Drehmodul | Transport in Kammer 1 | |
| **Zeittakt 13** | Beschichtung 2 in Kammer 2 | Beschichtung 2 in Kammer 3 | Beschichtung 1 in Kammer 1 | Einschleusen |
| **Zeittakt 14** | Beschichtung 2 in Kammer 2 | Beschichtung 2 in Kammer 3 | Beschichtung 1 in Kammer 1 | Einschleusen |
| **Zeittakt 15** | Drehmodul | Beschichtung 2 in Kammer 3 | Beschichtung 1 in Kammer 1 | Einschleusen |
| **Zeittakt 16** | Beschichtung 3 in Kammer 4 | Beschichtung 2 in Kammer 3 | Drehmodul | Transport in Kammer 1 |
| **Zeittakt 17** | Beschichtung 3 in Kammer 4 | Beschichtung 2 in Kammer 3 | Beschichtung 2 in Kammer 2 | Beschichtung 1 in Kammer 1 |
| **Zeittakt 18** | Beschichtung 3 in Kammer 4 | Beschichtung 2 in Kammer 3 | Beschichtung 2 in Kammer 2 | Beschichtung 1 in Kammer 1 |
| **Zeittakt 19** | Transport in Ausqanqsschleuse | Drehmodul | Beschichtung 2 in Kammer 2 | Beschichtung 1 in Kammer 1 |
| **Zeittakt 20** | Ausschleusen | Beschichtung 3 in Kammer 4 | Beschichtung 2 in Kammer 2 | Drehmodul |
| **Zeittakt 21** | | Beschichtung 3 in Kammer 4 | Beschichtung 2 in Kammer 2 | Beschichtung 2 in Kammer 3 |
| **Zeittakt 22** | | Beschichtung 3 in Kammer 4 | Beschichtung 2 in Kammer 2 | Beschichtung 2 in Kammer 3 |
| **Zeittakt 23** | | Transport in Ausganqsschleuse | Drehmodul | Beschichtung 2 in Kammer 3 |
| **Zeittakt 24** | | Ausschleusen | Beschichtung 3 in Kammer 4 | Beschichtung 2 in Kammer 3 |
| **Zeittakt 25** | | | Beschichtung 3 in Kammer 4 | Beschichtung 2 in Kammer 3 |
| **Zeittakt 26** | | | Beschichtung 3 in Kammer 4 | Beschichtung 2 in Kammer 3 |
| **Zeittakt 27** | | | Transport in Ausgangsschleuse | Drehmodul |
| **Zeittakt 28** | | | Ausschleusen | Beschichtung 3 in Kammer 4 |
| **Zeittakt 29** | | | | Beschichtung 3 in Kammer 4 |
| **Zeittakt 30** | | | | Beschichtunq 3 in Kammer 4 |
| **Zeittakt 31** | | | | Transport in Ausgangsschleuse |
| **Zeittakt 32** | | | | Ausschleusen |
| **Zeittakt 33** | | | | |
| **Zeittakt 34** | | | | |
| **Zeittakt 35** | | | | |

## Patentansprüche

1. Anlage (1) zur Behandlung von Substraten (S), umfassend:
wenigstens eine erste Prozesskammer (2), eine zweite Prozesskammer (3) und eine dritte Prozesskammer (4) zur Durchführung eines ersten und eines zweiten Behandlungsschritts,
eine zentrale Transportkammer (5), an die wenigstens die drei Prozesskammern (2, 3, 4) angeschlossen sind,
einen ersten Schleusenbereich (6) zum Ein- oder Ausschleusen der Substrate (S) in die Anlage (1) bzw. aus der Anlage (1), wobei die erste Prozesskammer (2) zwischen dem ersten Schleusenbereich (6) und der zentralen Transportkammer (5) in Reihe mit dem ersten Schleusenbereich (6) und der zentralen Transportkammer (5) angeordnet ist, und die zweite Prozesskammer (3) und die dritte Prozesskammer (4) unabhängig voneinander zugänglich an die zentrale Transportkammer (5) angeschlossen sind, **dadurch gekennzeichnet, dass** die Anlage (1) eine vierte Prozesskammer (8) und einen zweiten Schleusenbereich (7) zum Ausschleusen der Substrate aufweist, wobei die vierte Prozesskammer (8) an die zentrale Transportkammer (5) angeschlossen ist und zwischen dem zweiten Schleusenbereich (7) und der zentralen Transportkammer (5) in Reihe mit dem zweiten Schleusenbereich (7) und der zentralen Transportkammer (5) angeordnet ist.

2. Anlage (1) nach Anspruch 1, **dadurch gekennzeichnet, dass** die Anlage Transportmittel zum Transportieren der Substrate (S) durch die Anlage vom ersten Schleusenbereich (6) in die erste Prozesskammer (2) zur Durchführung eines ersten Behandlungsschritts, zum Transport von der ersten Prozesskammer (2) in die zentrale Transportkammer (5), zum Transport von der zentralen Transportkammer (5) wahlweise in die zweite Prozesskammer (3) oder in die dritte Prozesskammer (4) zur Durchführung eines zweiten Behandlungsschritts, und zum Rücktransport von der zweiten Prozesskammer (3) bzw. von der dritten Prozesskammer (4) in die zentrale Transportkammer (5) aufweist.

3. Anlage (1) nach Anspruch 1 oder 2, **dadurch gekennzeichnet, dass** die zentrale Transportkammer (5) eine Drehplattform (9) zum Ausrichten der Substrate (S) wahlweise zur Öffnung der zweiten Prozesskammer (3) oder zur Öffnung der dritten Prozesskammer (4) und zur Aufnahme der Substrate (S) aus der zweiten Prozesskammer (3) bzw. aus der dritten Prozesskammer (4) aufweist.

4. Anlage (1) nach einem der vorhergehenden Ansprüche, **dadurch gekennzeichnet, dass** benachbarte Kammern (2, 3, 4, 5, 6, 8, 7), insbesondere sämtliche benachbarte Kammern, durch Ventiltüren (10) gegeneinander verschließbar sind.

5. Anlage (1) nach einem der vorhergehenden Ansprüche, **dadurch gekennzeichnet, dass** die erste Prozesskammer (2) zur Durchführung eines ersten Behandlungsprozesses eingerichtet ist, und die zweite Prozesskammer (3) und die dritte Prozesskammer (4) zur Durchführung eines zweiten Behandlungsprozesses eingerichtet sind.

6. Anlage (1) nach einem der vorhergehenden Ansprüche, **dadurch gekennzeichnet, dass** die Anlage zur Ausbildung einer TFT-Metallisierung ausgebildet ist, wobei eine der Schichten in der Schichtfolge alternativ in der zweiten Prozesskammer (3) oder in der dritten Prozesskammer (4) aufgebracht wird.

7. Anlage (1) nach einem der vorhergehenden Ansprüche, **dadurch gekennzeichnet, dass** der erste Schleusenbereich (6) und/oder der zweite Schleusenbereich (7) jeweils eine Schleusenkammer (6a, 7a) und eine Transferkammer (6b, 7b) umfassen.

8. Beschichtungsverfahren, insbesondere zur Durchführung in einer Anlage (1) gemäß einem der vorhergehenden Ansprüche, umfassend die Schritte:
a) Einschleusen eines Substrats (S) in die Anlage (1);
b) Transportieren des Substrats (S) in eine erste Prozesskammer (2), die zwischen einem ersten Schleusenbereich (6) und einer zentralen Transportkammer (5) in Reihe mit dem ersten Schleusenbereich (6) und der zentralen Transportkammer (5) angeordnet ist, und Durchführen eines ersten Behandlungsschritts;
c) Transportieren des Substrats (S) in die zentrale Transportkammer (5);
d) Transportieren des Substrats (S) alternativ in die zweite Prozesskammer (3) oder in die dritte Prozesskammer (4), und Durchführen eines zweiten Behandlungsschritts;
e) Rücktransportieren des Substrats (S) in die zentrale Transportkammer (5);
f) Transportieren des Substrats (S) in eine vierte Prozesskammer (8), welche zwischen einem zweiten Schleusenbereich (7) und der zentralen Transportkammer (5) in Reihe mit dem zweiten Schleusenbereich (7) und der zentralen Transportkammer (5) angeordnet ist und Durchführen eines weiteren Behandlungsschritts; und
g) Ausschleusen des Substrats (S) aus der Anlage (1).

9. Verfahren nach Anspruch 8 , **dadurch gekennzeichnet, dass** das Substrat beim Einschleusen durch eine Einschleuskammer (6a) und eine Transferkammer (6b) transportiert wird.

10. Verfahren nach einem der Ansprüche 8 oder 9, **dadurch gekennzeichnet, dass** in der zweiten Prozesskammer (3) und in der dritten Prozesskammer (4) der gleiche Prozess abläuft.

11. Verfahren nach einem der Ansprüche 8 bis 10, **dadurch gekennzeichnet, dass** auf das Substrat (S) wenigstens drei Schichten zur TFT-Metallisierung aufgebracht werden.

12. Verfahren nach einem der Ansprüche 8 bis 11 , **dadurch gekennzeichnet, dass** die Substrate (S) während des Transports durch die Anlage (1) im Wesentlichen vertikal ausgerichtet sind.

13. Verfahren nach einem der Ansprüche 8 bis 12, **dadurch gekennzeichnet, dass** die Verfahrensschritte aus Anspruch 9 sequentiell zeitlich versetzt mit wenigstens einem zweiten Substrat (S) wiederholt werden.

## Claims

1. Machine (1) for treating substrates (S), comprising:
at least a first process chamber (2), a second process chamber (3) and a third process chamber (4) for executing a first and a second treatment stage,
a central transport chamber (5) to which at least the three process chambers (2, 3, 4) are connected,
a first lock area (6) for infeed or outfeed of the substrates (S) into the machine (1) or out of the machine (1), with the first process chamber (2) being arranged between the first lock area (6) and the central transport chamber (5) in series with the first lock area (6) and the central transport chamber (5), and the second process chamber (3) and the third process chamber (4) being connected to the central transport chamber (5) accessible independently from each other, **characterized by** the fact that the machine (1) has a fourth process chamber (8) and a second lock area (7) for outfeed of the substrates, with the fourth process chamber (8) being connected to the central transport chamber (5) and being arranged between the second lock area (7) and the central transport chamber (5) in series with the second lock area (7) and the central transport chamber (5).

2. Machine (1) in accordance with claim 1, **characterized by** the fact that the machine has transport means for transporting the substrates (S) through the machine from the first lock area (6) into the first process chamber (2) for the execution of a first treatment stage, for transporting from the first process chamber (2) into the central transport chamber (5), for transporting from the central transport chamber (5) optionally into the second process chamber (3) or into the third process chamber (4) for the execution of a second treatment stage, and for return transport from the second process chamber (3) or the third process chamber (4), respectively, into the central transport chamber (5).

3. Machine (1) in accordance with claim 1 or 2, **characterized by** the fact that the central transport chamber (5) has a rotary platform (9) for aligning the substrates (S) optionally towards the opening of the second process chamber (3) or towards the opening of the third process chamber (4) and for receiving the substrates (S) from the second process chamber (3) or from the third process chamber (4), respectively.

4. Machine (1) in accordance with any of the previous claims, **characterized by** the fact that adjacent chambers (2, 3, 4, 5, 6, 8, 7), especially all adjacent chambers, may be closed off from each other by valve doors (10).

5. Machine (1) in accordance with any of the previous claims, **characterized by** the fact that the first process chamber (2) is set up for the execution of a first treatment process and the second process chamber (3) and the third process chamber (4) are set up for the execution of a second treatment process.

6. Machine (1) in accordance with any of the previous claims, **characterized by** the fact that the machine is formed for the formation of a TFT metallization, with one of the layers in the layer sequence being alternatively applied in the second process chamber (3) or in the third process chamber (4).

7. Machine (1) in accordance with any of the previous claims, **characterized by** the fact that the first lock area (6) and/or the second lock area (7) each comprise a lock chamber (6a, 7a) and a transfer chamber (6b, 7b).

8. Coating method, especially for the execution in a machine (1) in accordance with one of the previous claims, comprising the stages:
a) Infeed of a substrate (S) into the machine (1);
b) Transport of the substrate (S) into a first process chamber (2) being arranged between the first lock area (6) and a central transport chamber (5) in series with the first lock area (6) and the central transport chamber (5), and execution of a first treatment step;
c) Transport of the substrate (S) into the central transport chamber (5);
d) Transport of the substrate (S) alternatively into the second process chamber (3) or into the third process chamber (4), and execution of a second treatment step;
e) Return transport of the substrate (S) into the central transport chamber (5);
f) Transport of the substrate (S) into a fourth process chamber (8) being arranged between a second lock area (7) and the central transport chamber (5) in series with the second lock area (7) and the central transport chamber (5) and execution of a further treatment step; and
g) Outfeed of the substrate (S) from the machine (1).

9. Method in accordance with claim 8, **characterized by** the fact that, during infeed, the substrate is transported through an infeed chamber (6a) and a transfer chamber (6b).

10. Method in accordance with either of claims 8 or 9, **characterized by** the fact that the same process occurs in the second process chamber (3) and in the third process chamber (4).

11. Method in accordance with any of claims 8 to 10, **characterized by** the fact that for the TFT metallization, at least three layers are applied to the substrate (S).

12. Method in accordance with any of claims 8 to 11, **characterized by** the fact that the substrate (S) are essentially vertically aligned during transport through the machine (1).

13. Method in accordance with any of claims 8 to 12, **characterized by** the fact that the method stages from claim 9 are sequentially staggered in time, with at least a second substrate (S) being repeated.

## Revendications

1. Installation (1) pour le traitement de substrats (S), ladite installation comportant : au moins une première chambre de réaction (2), une deuxième chambre de réaction (3) et une troisième chambre de réaction (4) destinées à mettre en oeuvre une première et une seconde étape de traitement,
une chambre de transport centrale (5) à laquelle sont raccordées les trois chambres de réaction (2, 3, 4),
une première zone de passage (6) destinée à introduire les substrats (S) dans l'installation (1) ou les retirer de l'installation (1), la première chambre de réaction (2) étant disposée entre la première zone de passage (6) et la chambre de transport centrale (5) en série avec la première zone de passage (6) et la chambre de transport centrale (5), et la deuxième chambre de réaction (3) et la troisième chambre de réaction (4) étant raccordées à la chambre de transport centrale (5) de manière à être accessibles indépendamment l'une de l'autre, **caractérisée en ce que** l'installation (1) comporte une quatrième chambre de réaction (8) et une deuxième zone de passage (7) destinée à retirer les substrats, la quatrième chambre de réaction (8) étant raccordée à la chambre de transport centrale (5) et étant disposée entre la deuxième zone de passage (7) et la chambre de transport centrale (5) en série avec la deuxième zone de passage (7) et la chambre de transport centrale (5).

2. Installation (1) selon la revendication 1, **caractérisée en ce que** l'installation comporte des moyens de transport destinés à transporter les substrats (S) à travers l'installation de la première zone de passage (6) dans la première chambre de réaction (2) destinée à mettre en oeuvre une première étape de traitement, à les transporter de la première chambre de réaction (2) dans la chambre de transport centrale (5), à les transporter de la chambre de transport centrale (5) au choix dans la deuxième chambre de réaction (3) ou dans la troisième chambre de réaction (4) destinées à mettre en oeuvre une deuxième étape de traitement et à les ramener de la deuxième chambre de réaction (3) ou de la troisième chambre de réaction (4) dans la chambre de transport centrale (5).

3. Installation (1) selon la revendication 1 ou 2, **caractérisée en ce que** la chambre de transport centrale (5) comporte une plate-forme rotative (9) destinée à orienter les substrats (S), au choix à ouvrir la deuxième chambre de réaction (3) ou à ouvrir la troisième chambre de réaction (4) et à recevoir les substrats (S) provenant de la deuxième chambre de réaction (3) ou de la troisième chambre de réaction (4).

4. Installation (1) selon l'une des revendications précédentes, **caractérisée en ce que** des chambres adjacentes (2, 3, 4, 5, 6, 8, 7), notamment toutes les chambres adjacentes, peuvent être fermées l'une par rapport à l'autre par des portes formant clapet (10).

5. Installation (1) selon l'une des revendications précédentes, **caractérisée en ce que** la première chambre de réaction (2) est destinée à mettre en oeuvre un premier processus de traitement, et la deuxième chambre de réaction (3) et la troisième chambre de réaction (4) sont destinées à mettre en oeuvre un deuxième processus de traitement.

6. Installation (1) selon l'une des revendications précédentes, **caractérisée en ce que** l'installation est conformée pour réaliser une métallisation TFT, l'une des couches de la succession de couches étant déposée alternativement dans la deuxième chambre de réaction (3) ou dans la troisième chambre de réaction (4).

7. Installation (1) selon l'une des revendications précédentes, **caractérisée en ce que** la première zone de passage (6) et/ou la deuxième zone de passage (7) comportent chacune une chambre de passage (6a, 7a) et une chambre de transfert (6b, 7b).

8. Procédé de revêtement, notamment destiné à être mis en oeuvre dans une installation (1) selon l'une des revendications précédentes, ledit procédé comportant les étapes consistant à :
a) introduire un substrat (S) dans l'installation (1) ;
b) transporter le substrat (S) dans une première chambre de réaction (2) qui est disposée entre une première zone de passage (6) et une chambre de transport centrale (5) en série avec la première zone de passage (6) et la chambre de transport centrale (5) et mettre en oeuvre une première étape de traitement ;
c) transporter le substrat (S) dans la chambre de transport centrale (5) ;
d) transporter le substrat (S) alternativement dans la deuxième chambre de réaction (3) ou dans la troisième chambre de réaction (4), et mettre en oeuvre une deuxième étape de traitement ;
e) ramener le substrat (S) dans la chambre de transport centrale (5) ;
f) transporter le substrat (S) dans la quatrième chambre de réaction (8), qui est disposée entre une deuxième zone de passage (7) et la chambre de transport centrale (5) en série avec la deuxième zone de passage (7) et la chambre de transport centrale (5), et mettre en oeuvre une autre étape de traitement ; et
g) retirer le substrat (S) de l'installation (1).

9. Procédé selon la revendication 8, **caractérisé en ce que** lors de l'introduction le substrat est transporté à travers une chambre d'introduction (6a) et une chambre de transfert (6b).

10. Procédé selon l'une des revendications 8 ou 9, **caractérisé en ce que** dans la deuxième chambre de réaction (3) et dans la troisième chambre de réaction (4) se déroule le même processus.

11. Procédé selon l'une des revendications 8 à 10, **caractérisé en ce que** au moins trois couches sont déposées sur le substrat pour réaliser la métallisation TFT.

12. Procédé selon l'une des revendications 8 à 11, **caractérisé en ce que** les substrats (S) sont orientés sensiblement verticalement pendant le transport à travers l'installation (1).

13. Procédé selon l'une des revendications 8 à 12, **caractérisé en ce que** les étapes de procédé de la revendication 9 sont répétées avec au moins un deuxième substrat (S) en étant décalées séquentiellement dans le temps.
